# EUROPÄISCHE PATENTSCHRIFT

(11) **EP 0 666 657 B1**
(45) Veröffentlichungstag und Bekanntmachung des Hinweises auf die Patenterteilung: **21.05.2003**
(21) Anmeldenummer: 95100896.0
(22) Anmeldetag: 24.01.1995
(51) Int. Cl.: H04B 10/158, H03F 3/08

(54) **Schaltungsanordnung für einen Lichtsignalempfänger**
Circuit for light signal receiver
Circuit pour récepteur de signaux lumineux

(30) Priorität: 07.02.1994 DE 4403985
(43) Veröffentlichungstag der Anmeldung: 09.08.1995
(73) Patentinhaber: NOKIA TECHNOLOGY GmbH, 44718 Bochum (DE)
(72) Erfinder: Reime, Gerd, D-75328 Schömberg 4 (DE)
(74) Vertreter: TER MEER STEINMEISTER & PARTNER GbR

(56) Entgegenhaltungen:
- DE-A- 3 825 006
- FR-A- 2 674 080
- US-A- 4 889 985
- PATENT ABSTRACTS OF JAPAN vol. 13 no. 62 (E-715) ,13.Februar 1989 & JP-A-63 250928 (NEC)

## Beschreibung

Die Erfindung betrifft eine Schaltungsanordnung für einen Lichtsignalempfänger zum Empfangen und Erkennen von Signalen, die auf optischem Wege übertragen werden. Der Lichtsignalempfänger wird im besonderen zur Vorselektion von Infrarotfernbediensignalen, die zum Einund Ausschalten eines elektronischen Gerätes ausgesandt werden, benutzt. Das Gerät kann z. B. ein Videogerät, eine Audioanlage oder ähnliches sein, das mittels einer drahtlosen Fernbedienung bedienbar ist.

Fernbedienbare Geräte weisen im allgemeinen drei Betriebszustände auf. Diese sind der ausgeschaltete Zustand, bei dem alle Baugruppen des Gerätes von der Netzspannung getrennt sind, der Wartebetrieb (Stand-by-Betrieb) und der Betriebszustand. Im Betriebszustand ist das Gerät voll funktionsfähig. Mit einem bekannten Fernbediensender kann das Gerät mittels modulierter Infrarotlichtsignale zwischen den beiden letztgenannten Betriebszuständen umgeschaltet werden. Damit wird mit der Fernbedienung das Gerät in einen energiearmen Wartebetrieb eingestellt, in dem ein Empfangsdekoder, der ein Wiedereinschalten mittels des Fernbediensenders ermöglicht, empfangsbereit gehalten wird.
Zur Lösung dieses Problems muß bei den bekannten Geräten immer noch ein beachtlicher Teil der Geräteelektronik zum Herstellen der Empfangsbereitschaft für das Fernbediensignal ständig aus dem Energienetz mit Betriebsenergie versorgt werden. Damit wird eine beachtliche Menge an elektrischer Energie benötigt. Beim Einsatz von Licht für die Übertragung von Signalen, insbesondere in Wohnräumen, tritt das Problem auf, daß wechselnde undefinierbare Raumlichtverhältnisse vorhanden sind. In der Umgebung eines fernbedienbaren Gerätes ist in der Regel bereits ständig ein störendes Umgebungslicht in der Form von Gleichlicht vorhanden, z. B. von der Sonne oder von Glühlampen. Auch gepulstes Licht, z. B. von Leuchtstofflampen oder das mit der Zeilenfrequenz modulierte Licht des Bildschirms des fernbedienbaren Geräts tritt oft störend auf.
Dieses parasitäre Licht wird auch dann, wenn der Lichtsensor mit optischen Filtermitteln ausgerüstet ist, mit empfangen und in eine entsprechende elektrische Signalkomponente gewandelt. Das gewandelte elektrische Signal besteht deshalb stets aus einer Gleichsignalkomponente, deren Wert in einem großen Bereich schwanken kann und einer überlagerten Wechselsignalkomponente, die das Nutzsignal darstellt. Der Pegel der Gleichsignalkomponente kann ein Vielfaches von der Amplitude des Nutzsignals betragen.
Parasitäres Licht kann bei starker Intensität den Lichtsensor und/oder den Empfangsverstärker übersteuern. In diesem Fall kann das Nutzsignal nicht ausreichend von der Gleichssignalkomponente getrennt und ausgewertet werden. Andererseits führt intensives parasitäres Licht zu einer erheblichen Reduzierung der Entfernung, aus der ein Gerät noch mittels Fernbediensender gesteuert werden kann. Deshalb sind in jeder Empfängerschaltung für Lichtsignale dieser Art umfangreiche Maßnahmen zum Unterdrücken von parasitärem Licht notwendig.

Um diese Maßnahmen zu unterstützen, werden die digitalen Zeichen der Lichtsignale als Impulsfolge, die ein serielles Kodewort bilden, z. B. biphasenkodiert oder pulsabstandskodiert, übertragen. So überträgt z. B. das bekannte Video-Tuning-System VTS 71 der Fa. Philips als Zeichen Lichtimpulse mit einer Dauer von etwa 0,5 ms, in Abständen zwischen 5 ms und 7,6 ms. Die Selektierbarkeit des Signals wird durch Tastung der Lichtimpulse mit einer Frequenz von ca. 38 kHz wesentlich erhöht. Die Kodeworte werden während des Betätigens des Fernbediensenders in Abständen von etwa 120 ms wiederholt.

Ein Fernbedienempfänger besteht im wesentlichen aus einem Lichtsensor für Infrarotlicht, einem Verstärker, Mitteln zum Unterdrücken der Einflüsse von parasitärem Licht und einem Demodulator zum Rückgewinnen der digitalen Zeichen aus dem gewandelten Fotostrom. Diese Zeichen wertet ein Fernbediendekoder aus und erzeugt Steuersignale, die im
Gerät bestimmte Betriebsfunktionen einstellen.
Als Lichtsensoren werden Fotodioden verwendet.

Ein Beispiel für einen rauscharmen, hochverstärtenden Lichtsignalempfänger ist im Patent Abstracts of Japan, Vol. 13, Nº 62 (E-715), 13. Februar 1989 & JP-A-63-250 928 (NEC) gezelgt. Bei diesem Lichtsignalempfänger sind zwar ein zweipoliger Lichtsensor und zwei Verstärkerbausteine vorhanden, aber bei diesem Lichtsignalempfänger steht die Verbesserung des Signal-Rauschverhättnisses im Vordergrund,. Maßnahmen zur Unterdrückung von Störsignalen, die vom Umgebungslicht erzeugt werden, sind nicht dargestellt.

In gebräuchlichen Fernbedienempfängern für Video- oder Audiogeräte, die z. B. den integrierten Schaltkreis TDA 4050 B benutzen, werden die Lichtsignale von einer Fotodiode empfangen und in einem geregelten, rauscharmen Verstärker auf einen hohen Ausgangspegel verstärkt. Ein am Eingang des Empfängers angeordneter Schwingkreis, der auf die Tastfrequenz abgestimmt ist, dient zum Unterdrücken des Einflusses von parasitärem Licht und verhindert, daß die in Sperrichtung betriebene Fotodiode bei einer hohen Beleuchtungsstärke in den Sättigungsbereich gelangt.
Bei dieser Schaltung ist nachteilig, daß Betriebsströme von einigen Milliampere benötigt werden und erst in Verbindung mit dem nachgeschalteten Fernbediendekoder das Lichtsignal hinreichend sicher identifiziert werden kann. Diese Lösung benötigt im Wartebetrieb insgesamt relativ viel Betriebsenergie.

Um diesen Mangel zu beseitigen, wurden Schaltungen für das Gerät vorgeschlagen, bei denen bis auf einen speziellen Empfänger für das Lichtsignal alle weiteren Baugruppen des Gerätes im Wartebetrieb stromlos geschaltet werden. Dabei wird ausgenutzt, daß der Fernbediensender beim Senden fortlaufend das Kodewort zum Auslösen einer entsprechenden Betriebsfunktion und die Geräteadresse wiederholt. Somit kann auch der Fernbediendekoder des Gerätes, der relativ viel Energie zum Betrieb benötigt, im Wartebetrieb stromlos geschaltet und erst nach dem Eintreffen und Erkennen eines Lichtsignals aktiviert werden.

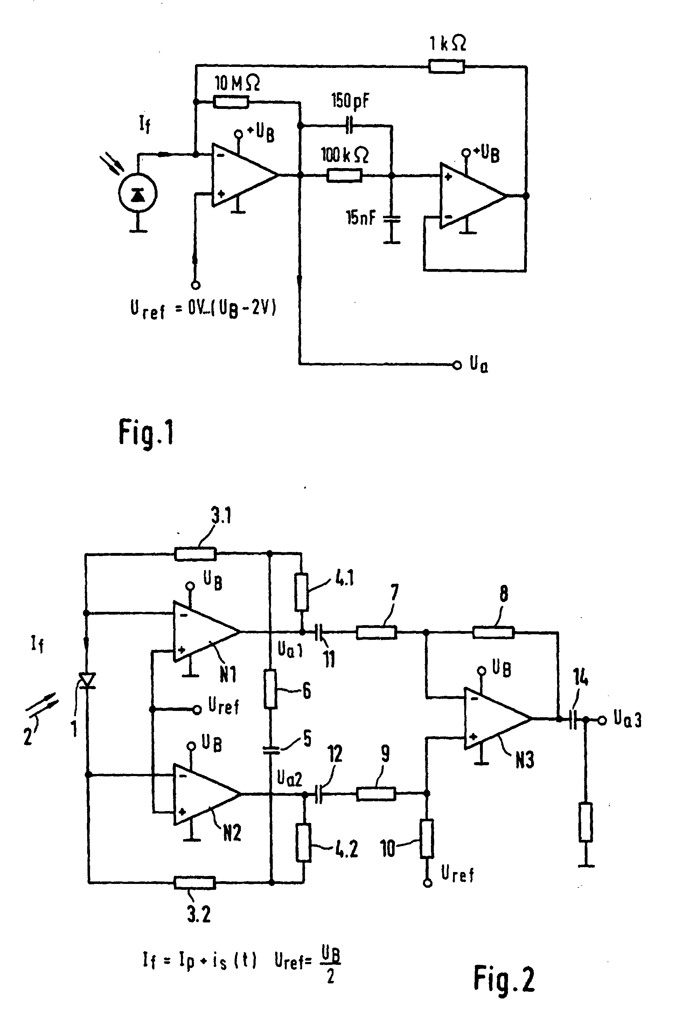

Eine weitere Schaltungsanordnung eines Lichtempfängers mit Mitteln zum Unterdrücken des Einflusses von parasitärem Licht ist aus dem Applikationsbuch: "Linear Circuits Data Book 1992", Volume 1, Operational Amplifiers der Fa. Texas Instruments Incorporated, USA, auf der Seite 2-722, Figur 47 bekannt. Diese Schaltungsanordnung ist zum besseren Verständnis in Figur 1 dargestellt und enthält zwei lineare Operationsverstärker, für die z. B. ein Präzisions-Doppel- Operationsverstärker in CMOS-Technik vom Typ TLC 27 M 2 verwendet werden kann.

Die Katode einer Fotodiode ist mit dem invertierenden Eingang eines ersten Operationsverstärkers und die Anode mit der Schaltungsmasse verbunden. Dieser Operationsverstärker ist über eine erste Schleife, die einen hochohmigen Widerstand von z. B. 10 Megaohm enthält, nur gering gegengekoppelt und weist beim Übertragen des Fotostroms einen hohen Strom-Spannungsfaktor auf, um auch bei geringer Helligkeitsamplitude, die das modulierte Signallicht gegenüber dem parasitärem Licht aufweist, eine ausreichende Amplitude des elektrischen Nutzsignals zu erzeugen.

Der nichtinvertierende Eingang des Operationsverstärkers ist mit einer Referenzspannung verbunden, deren Wert zwischen Null und der um zwei Volt reduzierten Betriebsspannung der Schaltung liegen kann. Damit wird der Arbeitspunkt der Fotodiode unabhängig vom empfangenen Licht in den Sperrbereich gelegt. Dieser Bereich gewährleistet eine ausreichende Übersteuerungsfestigkeit in bezug auf die Amplitude des modulierten Signallichts.

Das Ausgangssignal des ersten Operationsverstärkers, das zum Auswerten einer entsprechenden Schaltung zugeführt werden muß, wird zusätzlich über eine zweite Schleife, die einen weiteren Operationsverstärker enthält, der mit einem Tiefpaß als nichtinvertierender Gleichspannungsverstärker beschaltet ist, wesentlich stärker als über die erste Schleife durch Gleichspannung gegengekoppelt.
Diese Gegenkopplung bewirkt ein Kompensieren des Fotostroms, den das parasitäre Licht in der Fotodiode erzeugt.

Beim Eintreffen von Licht verringert sich entsprechend der Helligkeit der Sperrwiderstand der Fotodiode. Die Änderung des Fotostroms, der über die Gegenkopplung in die Fotodiode fließt, bewirkt im ersten Operationsverstärker ein Ansteigen der Ausgangsspannung. Der Tiefpaß sichert durch seine Funktion als Integrator, daß über die zweite Schleife nur die Gleichspannungskomponente der vom ersten Operationsverstärker erzeugten Ausgangsspannung auf die Katode der Fotodiode zurückgekoppelt wird.
Auf diese Weise wird nur der Anteil des von der Fotodiode erzeugten Signalstroms, der von Lichtimpulsen erzeugt wird und deren Frequenz oberhalb der Grenzfrequenz des Tiefpasses liegt, mit einem großen Strom-Spannungsfaktor zum Ausgang der Schaltung übertragen. Der Einfluß von parasitärem Licht wird weitestgehend unterdrückt.

Ein Nachteil dieser Lösung ist jedoch die hochohmige Gegenkopplung für den ersten Operationsverstärker, die bei ungünstigem Verhältnis von parasitärem Licht zum Signallicht zum Erreichen eines ausreichenden Strom-Spannungsfaktors erforderlich ist. Diese bewirkt eine unzureichenden Übertragungsfrequenz und erfordert eine relativ hohe Betriebsspannung für eine ausreichende Gleichsignalunterdrückung und Übersteuerungsfestigkeit. Aufgrund dieser Erfordernisse ist die Schaltung schlecht für die vorgesehene Anwendung geeignet.

Ein weiterer Nachteil der bekannten Lösungen ist, daß bei ungünstigem Verhältnis von Signallicht zu parasitärem Licht die Fotodiode mit einer Vorspannung betrieben wird, bei der sie im Sperrbereich arbeitet. In diesem Arbeitsbereich wird nur ein sehr kleiner Signalwechselstrom erzeugt und der nachfolgende Verstärker muß eine hohe Signalempfindlichkeit aufweisen, um den geringen Signalstrom in eine verwertbare Signalspannung zu übertragen.

Für die bekannten Lösungen ergibt sich daraus ein Problem bei der geometrischen Anordnung von Fotodiode, Signalleitung und Empfangsverstärker. Da die Fotodiode im Sperrbereich einen hohen Innenwiderstand aufweist, der bei einigen Hundert Kiloohm liegen kann, sind viele Teile der Schaltung besonders empfindlich für das Einkoppeln von Störsignalen wie z. B. Netzbrummen, Schaltsignale und anderes, die induktive und/oder kapazitiv durch Streufelder in die Schaltung gelangen können. Deshalb ist eine elektro-magnetische Abschirmung und ein kompakter Aufbau von Fotodiode und Verstärker notwendig, die dazu führen können, daß selbst die Eintrittsöffnung für das Licht bei der Fotodiode hinter einem Schirm aus feinmaschigem Drahtsieb angeordnet werden muß. Ein solcher kompakter und geschirmter Aufbau ist aufwendig und für die konstruktive und gestalterische Ausführung des Gerätes nachteilig.

Es ist daher Aufgabe der Erfindung eine Schaltung für einen Lichtempfänger anzugeben:
- die Signale mit einer relativ hohen Pulsfrequenz (z. B. 38 kHz) sicher demoduliert oder zumindest identifiziert, um ein Schaltsignal zu regenerieren
- die dabei so wenig Betriebsenergie benötigt, daß im Wartebetrieb möglichst keine Energie aus dem Netz zugeführt werden muß
- die unemfindlich ist gegen ein hohes Verhältnis der Intensitäten vom parasitären Licht zum Signallicht und
- die eine hohe Festigkeit gegen die Beeinflussung durch elektro-magnetische Störfelder aufweist.

Die Schaltung soll im Wartebetrieb eine Stromaufnahme von weniger als 10 µA aufweisen und mit möglichst geringer Betriebsspannung, die stark schwanken kann, störungsfrei arbeiten.

Die Schaltungsanordnung soll geeignet sein, auf einem gemeinsamen Schaltungschip realisiert zu werden.

Die Aufgabe wird mit den in Anspruch 1 genannten Merkmalen gelöst.

Das Wesen der Erfindung besteht darin, daß für jeden Anschlußpol eines Lichtsensors, insbesondere einer Fotodiode ein gesonderter, gleichartiger Gleichspannungsverstärker als Strom-Spannungswandler vorgesehen ist und daß die Anschlußpole jeweils mit einem gleichartigen, vorzugsweise dem invertierenden Eingang des ihnen zugeordneten Strom-Spannungswandlers verbunden sind, die über identische Gleichstrompfade frequenzabhängig gegengekoppelt sind, wobei die Gleichstrompfade mit den Anschlußpolen des Lichtsensors verbunden sind, so daß dieser von einem gegengekoppelten Gleichstrom durchflossen wird. Die Gleichstromgegenkopplung ist so stark eingestellt, daß die Gleichspannung über den Anschlußpolen des Lichtsensors unabhängig von der Höhe des parasitären Lichtes konstant ist und der Fotostrom, der von diesem Licht erzeugt wird, mit kleinem Strom-Spannungsfaktor übertragen wird.
Die Strom-Spannungswandler sind vorzugsweise mittels eines symmetrischen Filters der Art beschaltet, daß pulsierender Fotostrom, der mit einer Frequenz im Bereich der Pulsfrequenz des Signallichtes pulsiert, mit einem wesentlich höheren Strom-Spannungsfaktor zu den Ausgängen übertragen wird als der Fotostrom des parasitären niederfrequenten und gleichförmigen Lichtes. Ein symmetrisches Filter garantiert auch im Bereich der Pulsfrequenz des Signallichtes in den Strom-Spannungswandlern gleiche Strom-Spannungsfaktoren.
Die Ausgänge der Strom-Spannungswandler, zwischen denen der übertragene Fotostrom in der Form einer gegenphasig pulsierenden Spannung liegt, sind wechselstrommäßig jeweils mit einem Eingang eines Differenzverstärkers verbunden, der die Gleichtaktunterdrückung realisiert und damit alle Gleichtaktstörungen, wie den undefinierbaren Anteil des parasitären Lichtes und elektromagnetisch aufgenommene Störsignale unterdrückt und bevorzugt die Impulsspannung verstärkt.

Die Schaltung weist den Vorteil auf, daß unabhängig von der Höhe des parasitären Lichts bei guter Übersteuerungsfestigkeit und hoher Gleichsignalunterdrückung der Lichtsensor mit einem Arbeitspunkt in der Nähe vom Nullpunkt betrieben werden kann.

In diesem Bereich weisen Fotodioden günstige Eigenschaften als Signalwandler auf, wie mittlere Impedanzwerte, hohe Lichtempfindlichkeit und hohe Übertragungsgeschwindigkeit. Desweiteren ist die Schaltung wegen des nicht auf Masse bezogenen Signalflusses sehr unempfindlich für Einflüsse von elektrischen und magnetischen Störfeldern. Deshalb sind keine Maßnahmen zum Abschirmen und kein gedrängter kompakter Aufbau erforderlich. Der Sensor kann z. B. aus gestalterischen oder konstruktiven Gründen von den Strom-Spannungswandlern abgesetzt betrieben werden.

Ein weiterer Vorteil der erfinderischen Schaltung ist die Möglichkeit, wegen der mehrstufigen Verstärkung die Gegenkopplung der Verstärker mit Impedanzen von unter 100 Kiloohm zu realisieren und damit selbst bei der vorgesehen Arbeitsgeschwindigkeit langsame Operationsverstärker zu benutzen, z. B. den Typ MAX 409 der Firma Maxim Integrated Products, Inc., der mit einer geringen Betriebsspannung bei einem Betriebsstrom von wenigen Mikroampere betrieben werden kann.

Bei Verwendung dieser integrierten Schaltungen ist ein Betriebsstrom realisierbar, der in der Größenordnung des Stroms liegt, der in die Fotodiode geschickt werden muß, um den Fotostrom zu kompensieren, den das parasitäte Licht erzeugt.

Obwohl die Arbeitsgeschwindigkeit unterhalb der Frequenz des Signallichtes liegt, können die Schaltkreise bei dem geringen Betriebsstrom beim Eintreffen von Signallicht mit einer Pulsfrequenz von z. B. 38 kHz ein ausreichendes Signal am Ausgang der Schaltung erzeugen. Wobei die einzelnen Lichtpulse eines Zeichens von der Schaltung integriert werden und ein gut identifizierbares auswertbares elektrisches Signales entsteht, dessen Dauer jeweils etwa der Länge des Impulspaketes eines Zeichens entspricht.

Gemäß einer Weiterentwicklung der Erfindung können besonders vorteilhaft für die Strom-Spannungswandler und den Differenzverstärker programmierbare lineare Operationsverstärker, die als stromsparende Schaltungen ausgeführt sind, benutzt werden. Diese Schaltkreise besitzen einen Programmiereingang, mit dem Betriebsparameter wie Arbeitsgeschwindigkeit und Stromaufnahme einstellbar sind. Dabei ist eine hohe Arbeitsgeschwindigkeit bei höherem Betriebsstrom oder ein niedriger Betriebsstrom bei geringer Arbeitsgeschwindigkeit einstellbar.

Erfindungsgemäß wird an den Ausgang des Differenzverstärkers, ein Schwellwertschalter angeordnet, der die Programmiereingänge der programmierbaren Operationsverstärker vom Ausgangssignal der Schaltung abhängig steuert. Somit wird im Wartebetrieb die Schaltung in einen Betriebszustand gesteuert, in dem ein sehr geringer Betriebsstrom fließt und die Arbeitsgeschwindigkeit reduziert ist.
Der Vorteil der Schaltung besteht darin, daß diese Schaltung unmittelbar infolge des Eintreffens von gepulsten Lichtsignalen vom sehr energiearmen Wartezustand in einen Betriebszustand mit höherer Energieaufnahme versetzen kann, in dem eine ausreichende Arbeitsgeschwindigkeit vorhanden ist, um die einzelnen Pulse des Impulspakets eines Zeichens zu demodulieren, so daß eine Auswertung durch den aktivierten Dekoder erfolgen kann.

Die Erfindung wird nachfolgend anhand von vorteilhaften Ausführungsbeispielen näher erläutert. Die Erfindung ist jedoch nicht auf diese Ausführungsbeispiele beschränkt. Es sind auch noch andere spezielle Ausführungsformen, insbesondere hinsichtlich der Ausführung der einzelnen Verstärkerstufen, möglich und sinnvoll.

Die entsprechenden Zeichnungen zeigen:
- Figur 1: eine bekannte Schaltungsanordnung;
- Figur 2: eine Schaltungsanordnung gemäß dem Grundprinzip der Erfindung;
- Figur 3: Diagramme zum zeitlichen Signalverlauf an der Schaltungsanordnung gemäß dem Grundprinzip der Erfindung.
- Figur 4: eine Ausführungsform der Erfindung mit programmierbaren Verstärkern;

In der Figur 2 ist das Grundprinzip der erfinderischen Schaltungsanordnung zum Empfangen und Erkennen von gepulsten Lichtsignalen schematisch dargestellt.
Ein erster Pol einer Fotodiode 1 zum Empfangen von Lichtsignalen 2 ist mit dem invertierenden Eingang eines Strom-Spannungswandlers N1 und der andere Pol ist mit dem invertierenden Eingang eines Strom-Spannungswandlers N2 verbunden. Die Strom-Spannungswandler N1 und N2 sind Operationsverstärker, die jeweils mittels eines Gleichstrompfades, der die Widerstände 3.1 und 4.1 bzw. 3.2 und 4.2 enthält, über den invertierenden Eingang identisch gegengekoppelt sind.
Die Gleichstrompfade sind mit einer Serienschaltung aus einem Filterkondensator 5 und einem Widerstand 6 verbunden. Diese bilden mit den Widerständen 3.1, 3.2, 4.1 und 4.2 ein symmetrisches Tiefpaßfilter zum Sperren der Frequenz fo des Nutzsignals Uₐ₁ bzw. Uₐ₂ in den Gegenkopplungszweigen. Auf diese Weise übertragen die Strom-Spannungswandler N1 und N2 den Signalwechselstrom iₛ = f(fo) der Fotodiode mit einem wesentlich größeren Strom-Spannungsfaktor als den Gleichstrom Iₚ, den das parasitäre Licht erzeugt.
Ein Differenzverstärker N3, der ebenfalls ein Operationsverstärker sein kann und mit den Widerständen 7 bis 10 beschaltet ist, ist über die Kapazitäten 11 und 12 an die Ausgänge der Strom-Spannungswandler N1 und N2 angeschlossen.

Die nichtinvertierenden Eingänge der Strom-Spannungswandler N1 und N2 sind vorteilhaft mit einer gemeinsamen Referenzgleichspannung U_{ref} verbunden, so daß die Fotodiode 1 ohne Vorspannung als Fotoelement betrieben wird und bei Licht einen Fotostrom I_{f} erzeugt.

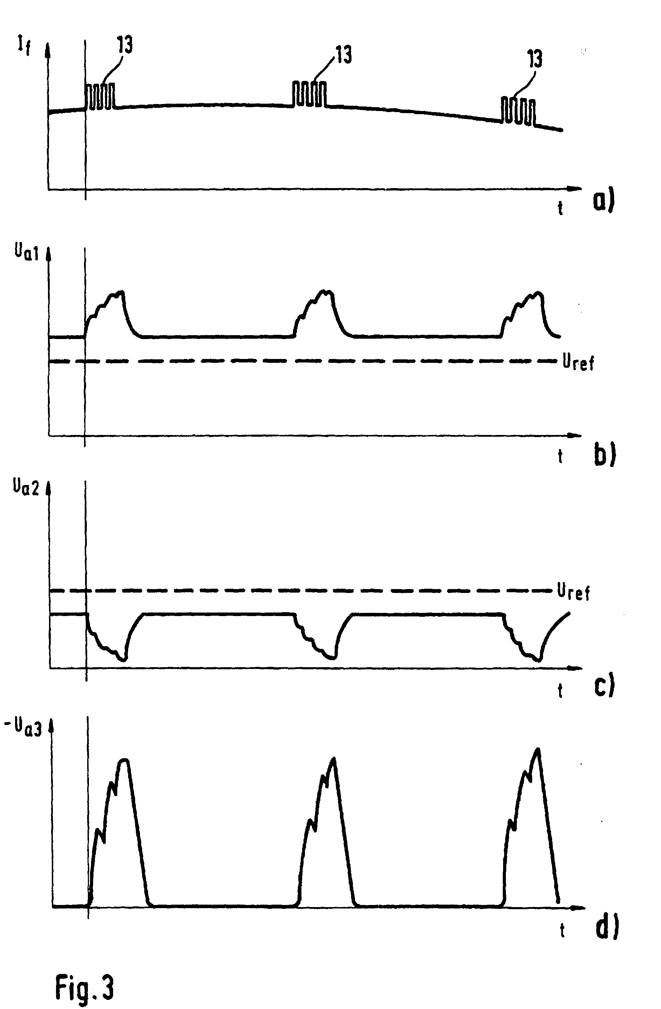

Die Funktion der Schaltung soll nachstehend in der Figur 3 anhand von Zeitdiagrammen dargestellt werden.

Das Diagramm a) zeigt den zeitlichen Verlauf des Fotostroms I_{f} = Iₚ + iₛ(t), welcher beim Aussenden eines Lichtsignals 2 vom gesamten einfallenden Licht in der Fotodiode 1 erzeugt wird. Der Fotostrom I_{f} besteht aus einer Gleichstromkomponente Iₚ, die das parasitäre Licht erzeugt und einem pulsierenden Signalstrom iₛ(t), welcher der Gleichstromkomponente Iₚ überlagert ist. Im dargestellten Beispiel ändert sich die Lichtintensität des parasitären Lichtes langsam. Jedes Zeichen des Lichtsignals besteht aus einem Lichtimpulspaket 13, bei dem ein Signalimpuls mit einer Pulsfrequenz fo = 38 kHz getastet wird und Pausen unterschiedlicher Länge, die zum Kennzeichnen des Signalinhalts dienen.

Der Fotostrom I_{f} fließt im Beispiel vom Ausgang des Strom-Spannungswandlers N1 über die Widerstände 3.1 und 4.1, der Fotodiode 1 den Widerständen 3.2 und 4.2 in den Ausgang des anderen Strom-Spannungswandlers N2.
Da die Strom-Spannungswandler N1, N2 identisch beschaltet sind, kann die Zuordnung der Anschlußpole zu den Strom-Spannungswandlern N1, N2 beliebig gewählt werden. Die Gleichstromgegenkopplung der Strom-Spannungswandler N1, N2 bewirkt, daß die Spannung über der Fotodiode unabhängig von der Höhe der Gleichstromkomponente Iₚ, in der Nähe von Null bleibt. Wie die Diagramme b) und c) zeigen, stellen sich an den Ausgängen der Strom-Spannungswandler N1, N2 infolge der Gleichstromkomponente Iₚ die Gleichspannungen Uₐ₁ = U_{ref} - Uₚ - uₛ(t) bzw. Uₐ₂ = U_{ref} + Uₚ + uₛ(t) ein, die dem Fotostrom entgegenwirken.

Die Widerstände 3.1 bis 4.2 sind so dimensioniert, daß selbst bei sehr starker Gleichstromkomponente Iₚ und einer geringen Betriebsspannung U_{B} die Strom-Spannungswandler nicht in die Sättigung gelangen.
Die Anordnung von Filterkondensator 5 und Widerstand 6 zwischen den Gleichstrompfaden vergrößert für den pulsierenden Signalstrom iₛ(t) den Strom-Spannungsfaktor. Die Diagramme b) und c) zeigen deshalb, daß die Ausgangsspannungen Uₐ₁ und Uₐ₂ bereits ein wesentlich besseres Signal-Störverhältnis zwischen den Komponenten uₛ(t) und Uₚ aufweisen, als der Fotostrom I_{f}.

Gleichzeitig ist erkennbar, daß selbst beim Einsatz von Operationsverstärkern mit Arbeitsgeschwindigkeiten die unterhalb der Pulsfrequenz fo liegen, an den Ausgängen der Strom-Spannungswandler auswertbare Spannungsimpulse entstehen.

Das Diagramm d) zeigt, daß Signal Uₐ₃ hinter dem Kondensator 14 am Ausgang des Differenzverstärkers N3.

Dieses Signal ist von niederfrequenten und Gleichstromkomponenten völlig befreit und kann als Schaltsignal oder zum Auswerten für einen Dekoder benutzt werden.

Die Schaltungsanordnung kann so konzipiert werden, daß z. B. mit einer Betriebsspannung aus einer Lithiumzelle ab 2,5 Volt und Gleichstrompfaden, die gegenüber dem Stand der Technik niederohmig sind, für das oben beschriebene Verhältnis von Signallicht und parasitärem Licht ein ausreichendes Ausgangssignal Uₐ₃ erzeugt wird, das den Empfang eines entsprechenden gepulsten Lichtsignals anzeigt. Die wesentlichen Vorteile der Schaltung sind eine sehr hohe Störfestigkeit gegen elektro-magnetische Fremdsignalen bei sehr guter Nutzsignalempfindlichkeit, so daß Maßnahmen zum Abschirmen nicht erforderlich sind, eine hohe Unterdrückung von parasitärem Licht und gute Übersteuerungsfestigkeit selbst bei niedriger Betriebsspannung.

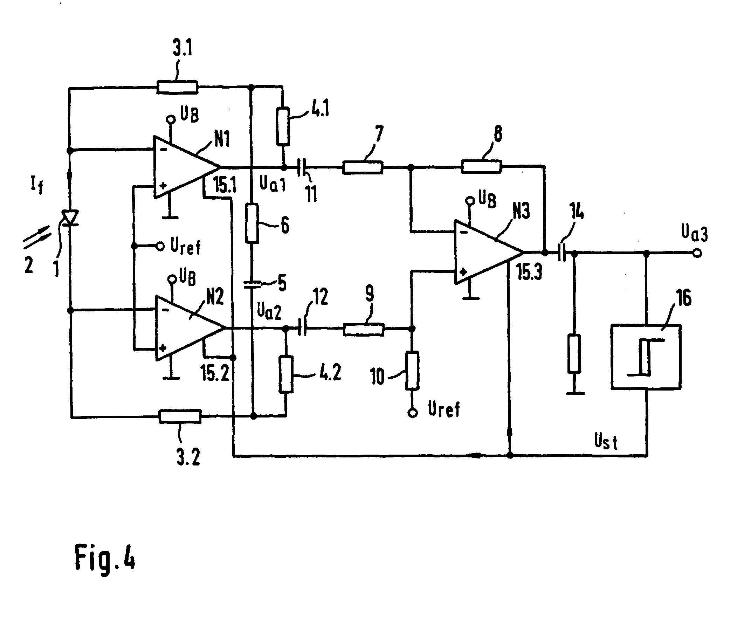

Die Figur 4 zeigt eine weitere Ausführungsform der erfinderischen Schaltung. In dieser Ausführungsform werden für die Strom-Spannungswandler N1, N2 und den Differenzverstärker N3 programmierbare lineare Operationsverstärker, die als stromsparende Schaltungen ausgeführt sind, benutzt. Diese Schaltkreise besitzen jeweils einen Programmiereingang 15.1, 15.2 bzw. 15.3, mit dem Betriebsparameter wie Arbeitsgeschwindigkeit und Stromaufnahme einstellbar sind, wobei Zustände zwischen einer hohen Arbeitsgeschwindigkeit bei höherem Betriebsstrom I_{B max} und ein niedriger Betriebsstrom I_{B min} bei geringer Arbeitsgeschwindigkeit einstellbar sind. An den Ausgang des Differenzverstärkers N3 ist ein Schwellwertschalter 16 angeordnet, der abhängig vom Ausgangssignal Uₐ₃ eine Steuerspannung Uₛₜ erzeugt, die die Programmiereingänge 15.1, 15.2 und 15.3 steuert. Somit wird im Wartebetrieb die Schaltung in einen Betriebszustand gesteuert, in dem der niedrige Betriebsstrom I_{B min} fließt und die Arbeitsgeschwindigkeit reduziert ist.

## Patentansprüche

1. Schaltungsanordnung für einen Lichtsignalempfänger zum Empfangen und Erkennen von gepulsten Lichtsignalen, denen Umgebungslicht mit undefinierbarer Intensität parasitär überlagert ist, mit einem zweipoligen Lichtsensor, der mit Mitteln zum Verstärken von Gleichsignalen verbunden ist, die eine frequenzabhängige Gegenkopplung aufweisen, wobei der Lichtsensor von einem Gegenkopplungsstrom durchflossen ist und der Signalanteil (Iₚ), den das Umgebungslicht erzeugt, durch Gegenkopplung der Verstärkerschaltung weitgehend kompensiert wird,
**dadurch gekennzeichnet, daß**
- für jeden Anschlußpol des Lichtsensors (1) ein Strom - Spannungswandler ( N1, N2) für Gleichstrom vorhanden ist, wobei jeder Anschlußpol mit einem gleichartigen Signaleingang von einem Strom - Spannungswandler (N1, N2) verbunden ist, wobei
- die Strom - Spannungswandler ( N1, N2)
-- identisches Übertragungsverhalten aufweisen,
-- für die gepulsten Lichtsignale als verstärkende Filter beschaltet sind und
-- Ober den Eingang, an dem sich der Anschlußpol des Lichtsensors ( 1 ) befindet, gleichstrommäßig und frequenzabhängig stark gegengekoppelt sind, wodurch die Gleichspannung über die Anschlußpole des Lichtsensors ( 1 ) unabhängig von der Intensität des parasitären Lichts konstant ist, und daß
-- die Ausgänge der Strom - Spannungswandler ( N1, N2 ) wechselstrommäßig jeweils mit einem Eingang eines Differenzverstärkers (N3) verbunden sind.

2. Schaltungsanordnung nach Anspruch 1, **dadurch gekennzeichnet, daß** der Lichtsensor (1) eine Fotodiode ohne Vorspannung ist.

3. Schaltungsanordnung nach Anspruch 1, **dadurch gekennzeichnet, daß** die gleichartigen Signaleingänge der Strom - Spannungswandler ( N1, N2) invertierende Eingänge sind.

4. Schaltungsanordnung nach Anspruch 1, **dadurch gekennzeichnet, daß** die frequenzabhängige Gegenkopplung für beide Strom - Spannungswandler ein symmetrisches Filter ist.

5. Schaltungsanordnung nach Anspruch 1, **dadurch gekennzeichnet, daß** die Strom - Spannungswandler ( N1, N2 ) und der Differenzverstärker ( N3) lineare Operationsverstärker sind, die als Low - Power - C-MOS - Schaltung ausgeführt sind, wobei deren Arbeitsgeschwindigkeit unterhalb der Frequenz des Signallichts liegt.

6. Schaltungsanordnung nach Anspruch 1, **dadurch gekennzeichnet, daß** die Strom - Spannungswandler ( N1, N2) und der Differenzverstärker ( N3) lineare Operationsverstärker sind, die auf einem Schaltungschip enthalten sind.

7. Schaltungsanordnung nach Anspruch 1, **dadurch gekennzeichnet, daß** die Strom - Spannungswandler ( N1, N2 ) und der Differenzverstärker ( N3 ) programmierbare lineare Operationsverstärker sind, die jeweils einen Programmiereingang (15.1, 15.2 und 15.3 ) zum Einstellen von Betriebsstrom (I_{Bmin} bis I_{Bmax}) und Arbeitsgeschwindigkeit enthalten und
- daß die Programmiereingänge (15.1, 15.2 und 15.3 ) mit einem Schwellwertschalter ( 16 ) verbunden sind, an dessen Ausgang in Abhängigkeit vom erkannten übertragenen Signal ein Steuersignal ( Uₛₜ ) liegt zum Einstellen des niedrigen Betriebsstroms ( I_{Bmin} ) der Operationsverstärker (N1, N2, N3 ) im Wartebetrieb.

## Claims

1. Circuit arrangement for a light signal receiver for receiving and recognizing pulsed light signals which are parasitically superimposed by ambient light of an undefinable intensity, having a two-pole light sensor which is connected to means for amplifying d.c. signals having frequency-dependent negative feedback, a negative-feedback current flowing through the light sensor and the signal component (Iₚ) generated by the ambient light being largely compensated by the negative feedback of the amplifier circuit,
**characterized in that**
- a current-voltage transformer (N1, N2) for direct current is available for each terminal pole of the light sensor (1), each terminal pole being connected to an identical signal input of a current-voltage transformer (N1, N2),
- the current-voltage transformers (N1, N2)
- - having an identical response characteristic,
- - being connected as amplifying filters for the pulsed light signals, and
- - having a high level of frequency-dependent d.c. negative feedback via the input at which the terminal pole of the light sensor (1) is located, by means of which the d.c. voltage across the terminal poles of the light sensor (1) is constant independently of the intensity of the parasitic light, and **in that**
- - the outputs of the current-voltage transformers (N1, N2) are each a.c.-connected to an input of a differential amplifier (N3).

2. Circuit arrangement according to Claim 1, **characterized in that** the light sensor (1) is a photodiode without bias.

3. Circuit arrangement according to Claim 1, **characterized in that** the identical signal inputs of the current-voltage transformers (N1, N2) are inverting inputs.

4. Circuit arrangement according to Claim 1, **characterized in that** the frequency-dependent negative feedback is a symmetrical filter for the two current-voltage transformers.

5. Circuit arrangement according to Claim 1, **characterized in that** the current-voltage transformers (N1, N2) and the differential amplifier (N3) are linear operational amplifiers which are designed as a low-power CMOS circuit in which their operating speed is below the frequency of the signal light.

6. Circuit arrangement according to Claim 1, **characterized in that** the current-voltage transformers (N1, N2) and the differential amplifier (N3) are linear operational amplifiers which are contained on one circuit chip.

7. Circuit arrangement according to Claim 1, **characterized in that** the current-voltage transformers (N1, N2) and the differential amplifier (N3) are programmable linear operational amplifiers which each contain a programming input (15.1, 15.2 and 15.3) for setting operating current (I_{Bmin} to I_{Bmax}) and operating speed, and
- **in that** the programming inputs (15.1, 15.2 and 15.3) are connected to a threshold-value switch (16) at the output of which there is present in dependence on the recognized transformed signal a control signal (Uₛₜ) for setting the low operating current (I_{Bmin}) of the operational amplifiers (N1, N2, N3) in the stand-by mode.

## Revendications

1. Circuit pour un récepteur de signaux lumineux pour la réception et l'identification de signaux lumineux pulsés, dont la lumière ambiante est brouillée de manière parasite avec une intensité indéfinissable, doté d'un capteur de lumière bipolaire raccordé à des moyens pour amplifier des signaux d'égalité qui présentent un contrecouplage en fonction de la fréquence, le capteur de lumière étant parcouru par un courant de contrecouplage et la fraction de signal (lₚ) qui crée la lumière ambiante étant compensée dans une large mesure par le contrecouplage du montage amplificateur,
**caractérisé en ce que**
- un transformateur courant-tension (N1, N2) pour le courant continu est présent pour chaque pôle de raccordement du capteur de lumière (1), chacun des pôles de raccordement étant raccordé à une entrée de signal de même type d'un transformateur courant-tension (N1, N2),
- les transformateurs courant-tension (N1, N2),
-- présentant des caractéristiques de transmission identiques,
-- étant câblés comme filtre amplifiant pour les signaux lumineux pulsés et
-- étant contrecouplés fortement en fonction de la fréquence et selon le courant continu sur l'entrée à laquelle se trouve le pôle de raccordement du capteur de lumière (1), la tension continue étant constante sur les pôles de raccordement du capteur de lumière (1), indépendamment de l'intensité de la lumière parasite, et **en ce que**
-- les sorties des transformateurs courant-tension (N1, N2) sont raccordées selon le courant alternatif respectivement à une entrée d'un amplificateur différenciateur (N3).

2. Circuit selon la revendication 1, **caractérisé en ce que** le capteur de lumière (1) est une photodiode sans polarisation.

3. Circuit selon la revendication 1, **caractérisé en ce que** les entrées de signaux de même type des transformateurs courant-tension (N1, N2) sont des entrées inversantes.

4. Circuit selon la revendication 1, **caractérisé en ce que** le contrecouplage en fonction de la fréquence des deux transformateurs courant-tension est un filtre symétrique.

5. Circuit selon la revendication 1, **caractérisé en ce que** les transformateurs courant-tension (N1, N2) et l'amplificateur différenciateur (N3) sont des amplificateurs opérationnels linéaires, qui sont réalisés comme circuit CMOS-Low-Power, leur vitesse de traitement étant située en dessous de la fréquence de la lumière du signal.

6. Circuit selon la revendication 1, **caractérisé en ce que** les transformateurs courant-tension (N1, N2) et l'amplificateur différenciateur (N3) sont des amplificateurs opérationnels linéaires contenus sur une puce de circuit.

7. Circuit selon la revendication 1, **caractérisé en ce que** les transformateurs courant-tension (N1, N2) et l'amplificateur différenciateur (N3) sont des amplificateurs opérationnels linéaires programmables qui contiennent respectivement une entrée de programmation (15.1, 15.2 et 15.3) pour le réglage du courant de régime (l_{Bmin} à l_{Bmax}) et une vitesse de travail et
- **en ce que** les entrées de programmation (15.1, 15.2 et 15.3) sont raccordées à un interrupteur de seuil différentiel (16), à la sortie duquel, en fonction du signal transmis identifié, un signal de commande (Uₛₜ) se trouve pour le réglage du courant de régime bas (l_{Bmin}) des amplificateurs différenciateurs (N1, N2, N3) en service d'attente.
